# EUROPÄISCHE PATENTSCHRIFT

(11) **EP 3 309 573 B1**
(45) Veröffentlichungstag und Bekanntmachung des Hinweises auf die Patenterteilung: **24.07.2019**
(21) Anmeldenummer: 17176022.6
(22) Anmeldetag: 14.06.2017
(51) Int. Cl.: H03B 21/01, G01R 33/36, G01R 33/341

(54) **LOKAL LO GENERATOR FÜR MRT LOKALSPULEN MIT FREQUENZUMSETZER**
LOCAL LO GENERATOR FOR MRT LOCAL COILS WITH FREQUENCY CONVERTER
BOBINES IRM LOCALES COMPRENANT UN CONVERTISSEUR DE FRÉQUENCE

(43) Veröffentlichungstag der Anmeldung: 18.04.2018
(73) Patentinhaber: Siemens Healthcare GmbH, 91052 Erlangen (DE)
(72) Erfinder: Bollenbeck, Jan, 91330 Eggolsheim (DE); Oppelt, Ralph, 91080 Uttenreuth (DE); Rehner, Robert, 91077 Neunkirchen am Brand (DE); Vester, Markus, 90471 Nürnberg (DE)

(56) Entgegenhaltungen:
- DE-A1-102010 027 672
- DE-B3-102009 008 623
- US-A1- 2008 003 968

## Beschreibung

Die Erfindung betrifft eine Lokalspule sowie einen Magnetresonanztomographen mit einer Lokalspule. Die Lokalspule weist eine Vorrichtung zum Bereitstellen eines ersten Mischfrequenzsignals und eines zweiten Mischfrequenzsignals mittels eines ersten Hilfsfrequenzsignals und eines zweiten Hilfsfrequenzsignals auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Antennen, sogenannte Lokalspulen verwendet, die zur Erzielung eines besseren Signal-Rauschabstandes unmittelbar am Untersuchungsobjekt angeordnet werden.

Um die Zahl der Kabelverbindungen zwischen Lokalspule und Magnetresonanztomograph zu verringern, können die Signale mehrerer Antennenspulen mittels Frequenzmultiplex gemeinsam übertragen werden. Dazu ist die Umsetzung auf unterschiedliche Trägerfrequenzen, auch als Zwischenfrequenz bezeichnet, durch Mischer erforderlich. Da für die Bildgebung mit Magnetresonanzsignalen Frequenz und Phase der Signale von großer Bedeutung sind, ist es dabei erforderlich, diese Größen auch bei der Übertragung mit Frequenzmultiplex zu erhalten. Es werden daher üblicherweise die die Hilfssignale zum Mischen zentral im Magnetresonanztomographen mit hoher Präzision erzeugt und dann an die Lokalspulen verteilt.

Die Druckschrift DE 10 2008 062 855 A1 beschreibt ein System, bei dem eine Vielzahl von Signalen von einer Basisstation zu einem Satelliten und in umgekehrter Richtung und durch jeweils eine Bandpassfilterbank spektral voneinander getrennt werden.

Aus der Druckschrift DE 10 2009 008 623 A1 ist beispielsweise ein Magnetresonanztomograph bekannt, bei dem für ein Frequenzmultiplex Mischfrequenzsignale über separate Kabel zugeführt werden.

Die Druckschrift DE 10 2010 027672 A1 beschreibt eine Vorverarbeitungseinrichtung für Empfangssignale einer Lokalspule in einer Magnetresonanzeinrichtung, die eine Anordnung zur Bereitstellung wenigstens eines Hilfsfrequenzsignales einer Hilfsfrequenz mit einem Frequenzvervielfacher zur Erzeugung des Hilfsfrequenzsignals aufweist.

Aus der Druckschrift US 2008/0003968 A1 ist eine Vorrichtung in einer drahtlosen Übertragungseinrichtung bekannt, die einen Schaltkreis zur Erzeugung eines ersten Frequenzsignals aufweist. Ein lokaler Oszillator kann vorgesehen sein, der einen Frequenzteiler und einen spiegelfrequenzunterdrückenden Mischer aufweist.

Die Druckschrift DE 10 2009 008 623 B3 offenbart eine Anordnung zur Übertragung von Magnetresonanzsignalen. Die Anordnung weist einen ersten und einen zweiten Frequenzkonverter auf, die mit einem zugeführten Magnetresonanzsignal und einem Oszillatorsignal eine erste und eine zweite Zwischenfrequenz zur gemeinsamen Übertragung bilden.

Bei Systemen mit niedrigeren Magnetfeldern sind die Larmorfrequenzen niedriger, sodass die Frequenzschemata der Hochfeldsysteme zur Vermeidung von Störungen durch die Zwischenfrequenzen nicht mehr anwendbar sind.

Es ist daher eine Aufgabe der vorliegenden Erdfindung, eine Vorrichtung bereitzustellen, die eine flexiblere Frequenzwahl erlaubt.

Die Aufgabe wird durch eine erfindungsgemäße Vorrichtung nach Anspruch 1 sowie einen Magnetresonanztomographen nach Anspruch 6 gelöst.

Die erfindungsgemäße Lokalspule weist eine Vorrichtung zum Bereitstellen eines ersten Mischfrequenzsignals und eines zweiten Mischfrequenzsignals mittels eines ersten Hilfsfrequenzsignals und eines zweiten Hilfsfrequenzsignals auf. Das erste Hilfsfrequenzsignal und das zweite Hilfsfrequenzsignal weisen dabei unterschiedliche Frequenzen auf in dem Sinne, dass sich zumindest die Signalanteile mit den größten Amplituden in der Frequenz unterscheiden. Das erste Hilfsfrequenzsignal und das zweite Hilfsfrequenzsignal werden beispielsweise von einem Frequenzgenerator eines Magnetresonanztomographen bereitgestellt. Dabei ist höchstens die Frequenz des ersten Mischfrequenzsignals gleich einer Frequenz des ersten Hilfsfrequenzsignal oder des zweiten Hilfsfrequenzsignal. Mit anderen Worten, zumindest eine der beiden Mischfrequenzsignale wird nicht unmittelbar der Vorrichtung zugeführt, sondern durch ein Mischen aus dem ersten und dem zweiten Hilfsfrequenzsignal abgeleitet. Dabei wird unter Mischen eine Signalverarbeitung verstanden, die Intermodulationsprodukte des ersten und/oder zweiten Hilfsfrequenzsignals erzeugt. Dies kann analog durch nichtlineare Kennlinien, beispielsweise von Dioden oder Verstärkerelementen erreicht werden. In der digitalen Signalverarbeitung sind beispielsweise Multiplikation, Potenz- oder Exponentialfunktionen oder auch binäre Funktionen wie UND bzw. ODER-Funktion zur Erzeugung von Intermodulationsprodukten denkbar. Die Funktionseinheit, die das Mischen der ersten und der zweiten Hilfsfrequenz bzw. von daraus abgeleiteten Signalen ausführt, wird dabei im Folgenden als Hilfsmischer bezeichnet.

Die erfindungsgemäße Lokalspule weist Antennenspulen auf, die ausgelegt sind, Magnetresonanzsignale aus dem Körper des Patienten zu empfangen.

Die erfindungsgemäße Lokalspule weist weiterhin einen ersten Mischer und einen zweiten Mischer auf, der ausgelegt ist, die Magnetresonanzsignale für eine Übertragung mittels Frequenzmultiplex auf einer gemeinsamen Leitung auf unterschiedliche Zwischenfrequenzen umzusetzen.

Die Vorrichtung weist einen Lokaloszillator auf, der ausgelegt ist, das erste Mischfrequenzsignal und das zweite Mischfrequenzsignal für den ersten Mischer und den zweiten Mischer bereitzustellen.

Die erfindungsgemäße Vorrichtung weist einen derartigen Hilfsmischer auf, der ausgelegt ist, aus dem ersten Hilfsfrequenzsignal und dem zweiten Hilfsfrequenzsignal das zweite Mischfrequenzsignal zu erzeugen. Es ist darüber hinaus auch denkbar, dass das erste Mischfrequenzsignal ebenfalls durch den Hilfsmischer oder einen weiteren Hilfsmischer aus dem ersten Hilfsfrequenzsignal und dem zweiten Hilfsfrequenzsignal erzeugt wird, wobei die Frequenz des ersten Mischfrequenzsignals ungleich einer Frequenz des ersten Hilfsfrequenzsignals und des zweiten Hilfsfrequenzsignals und des zweiten Mischfrequenzsignals ist. Es ist aber ebenso denkbar, dass die Frequenz des ersten Mischfrequenzsignals gleich der Frequenz des ersten Hilfsfrequenzsignal oder des zweiten Hilfsfrequenzsignals ist.

Die Lokalspule weist einen Signaleingang auf, der in einer ersten Signalverbindung mit der Vorrichtung steht. Die Lokalspule ist ausgelegt, das erste Hilfsfrequenzsignal und das zweite Hilfsfrequenzsignal gemeinsam über den Signaleingang zu empfangen und der Vorrichtung über die erste Signalverbindung zuzuführen.

Auf vorteilhafte Weise ermöglicht es die erfindungsgemäße Vorrichtung, aus zwei Hilfsfrequenzsignalen, die über einen gemeinsamen Signaleingang zugeführt werden, zwei unterschiedliche Mischfrequenzen zu erzeugen und so die Wahl der Frequenzen der Hilfsfrequenzsignale von der Wahl der Frequenzen der Mischfrequenzsignale um mindestens einen Freiheitsgrad zu entkoppeln und flexibler zu gestalten.

Der erfindungsgemäße Magnetresonanztomograph teilt die Vorteile der erfindungsgemäßen Lokalspule.

Weitere vorteilhafte Ausführungsformen sind in den Unteransprüchen angegeben.

In einer denkbaren Ausführungsform der erfindungsgemäßen Lokalspule weist die Vorrichtung einen ersten Diplexer auf. Der erste Diplexer steht über eine zweite Signalverbindung und eine dritte Signalverbindung mit dem Hilfsmischer in Signalverbindung.

Der erste Diplexer ist ausgelegt, die über die erste Signalverbindung gemeinsam zugeführten erste Hilfsfrequenzsignal und zweite Hilfsfrequenzsignal zu trennen und getrennt über die zweite Signalverbindung und die dritte Signalverbindung dem Hilfsmischer zuzuführen. Beispielsweise kann durch einen Hochpass und/oder Tiefpass und/oder Bandpässe als Filter das erste Hilfsfrequenzsignal von dem zweiten Hilfsfrequenzsignal separiert werden und dann getrennt über die zweite Signalverbindung das erste Hilfsfrequenzsignal und die dritte Signalverbindung das zweite Hilfsfrequenzsignal dem Hilfsmischer zugeführt werden. Die Filter können beispielsweise durch passive LC-Kreise, aktive LC- oder RC-Filter oder in digitaler Signalverarbeitung durch entsprechende Schaltungen und/oder Algorithmen in einer Signalverarbeitungsressource wie einem Signalprozessor oder FPGA bereitgestellt sein.

Die Trennung des ersten Hilfsfrequenzsignals von dem zweiten Hilfsfrequenzsignals erlaubt es in dem nachfolgenden Hilfsmischer vorteilhafte Schaltungstechniken zu verwenden. Beispielsweise können in einem Ringmischer das ursprüngliche erste Hilfsfrequenzsignal und das zweite Hilfsfrequenzsignal gegenüber dem ersten Mischfrequenzsignal und dem zweiten Mischfrequenzsignal unterdrückt werden.

In einer denkbaren Ausführungsform der erfindungsgemäßen Vorrichtung ist der Hilfsmischer ausgelegt, das zweite Mischfrequenzsignal durch Intermodulation dritter Ordnung zu erzeugen.

Eine Intermodulation dritter Ordnung lässt sich auf vorteilhafte Weise durch einen einfachen Diodenverzerrer, d.h. eine einzelne Diode oder ein antiparalleles Paar von Dioden bereitstellen, der am Signalausgang auch die ursprünglichen Hilfsfrequenzsignale für eine weitere Verwendung ausgibt.

In einer möglichen Ausführungsform der erfindungsgemäßen Lokalspule weist die Vorrichtung ein Bandpassfilter auf, das eine vierte Signalverbindung zu einem ersten Signalausgang des Hilfsmischers aufweist. Das Bandpassfilter ist ausgelegt, das zweite Mischfrequenzsignal aus einem Ausgangssignal des Hilfsmischers zu filtern. Beispielsweise kann das Ausgangssignal des Hilfsmischers noch Anteile des ersten Hilfsfrequenzsignals und/oder des zweiten Hilfsfrequenzsignals oder Mischprodukte höherer Ordnung aufweisen, die durch das Bandpassfilter entfernt werden.

Das Bandpassfilter ermöglicht auf vorteilhafte Weise die Verwendung eines einfachen Frequenzschemas und/oder Hilfsmischers, da unerwünschte Frequenzen durch das Bandpassfilter nachträglich ausgefiltert werden.

In einer denkbaren Ausführungsform der erfindungsgemäßen Lokalspule weist der Hilfsmischer einen Diodenverzerrer auf. Ein Diodenverzerrer ist eine besonders einfache und kostengünstige Möglichkeit zur Erzeugung von Intermodulationsprodukten höherer Ordnung.

In einer möglichen Ausführungsform des erfindungsgemäßen Magnetresonanztomographen weist der Magnetresonanztomograph einen Empfänger mit einem Signaleingang auf. Der Empfänger ist dabei ausgelegt, Empfangssignale mit einer Frequenz eines Mischsignals aus einem Magnetresonanzsignal mit Larmorfrequenz und erstem Mischfrequenzsignal und/oder zweitem Mischfrequenzsignal am Signaleingang zu empfangen und auszuwerten.

Auf vorteilhafte Weise ist der Magnetresonanztomograph in der Lage, die mittels der Hilfsfrequenzen erzeugten und im Frequenzmultiplex über eine gemeinsame Leitung übertragenen Magnetresonanzsignale auszuwerten.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen mit einer beispielhaften erfindungsgemäßen Lokalspule;
- Fig. 2: eine schematische Darstellung einer Ausführungsform einer erfindungsgemäßen Lokalspule;
- Fig. 3: eine schematische Darstellung eines Lokaloszillators einer Ausführungsform einer erfindungsgemäßen Lokalspule;
- Fig. 4: eine schematische Darstellung eines Lokaloszillators einer Ausführungsform einer erfindungsgemäßen Lokalspule;

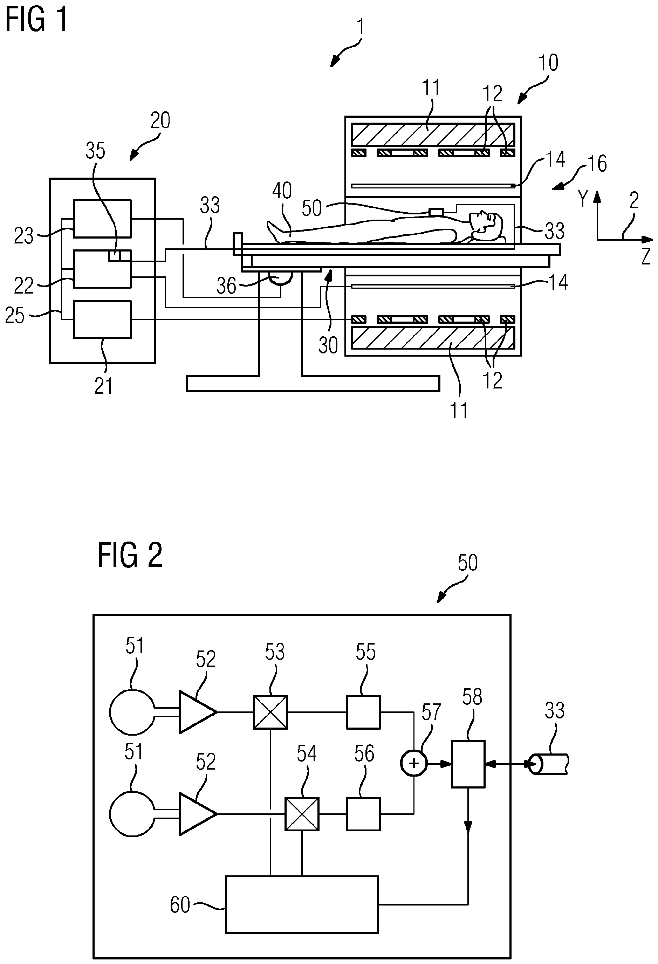

Fig. 1 zeigt eine schematische Darstellung einer Ausführungsform eines erfindungsgemäßen Magnetresonanztomographen 1.

Die Magneteinheit 10 weist einen Feldmagneten 11 auf, der ein statisches Magnetfeld B0 zur Ausrichtung von Kernspins von Proben bzw. Patienten 40 in einem Aufnahmebereich erzeugt. Der Aufnahmebereich ist in einem Patiententunnel 16 angeordnet, der sich in einer Längsrichtung 2 durch die Magneteinheit 10 erstreckt und von der Verfahreinheit 36 bewegbar ist. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 40 emittierte Resonanzsignale zu empfangen und über eine Signalleitung abzugeben. Bevorzugter Weise wird aber die Körperspule 14 für das Empfangen des Hochfrequenzsignals durch Lokalspulen 50 ersetzt, die in dem Patiententunnel 16 nahe am Patient 40 angeordnet sind. Es ist aber auch denkbar, dass die Lokalspule 50 zum Senden und Empfangen ausgelegt ist.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 40 zu erzeugen. Dabei können Pulsleistungen im Bereich von Kilowatt erreicht werden.

Weiterhin weist die Hochfrequenzeinheit 22 einen Frequenzgenerator 35 auf, der ausgelegt ist, für die Lokalspule, wie nachfolgend erläutert, ein erstes Hilfsfrequenzsignal und ein zweites Hilfsfrequenzsignal zu erzeugen und über die Signalverbindung 33 zu der Lokalspule 50 zu übertragen.

In Fig. 2 ist eine erfindungsgemäße Lokalspule schematisch im Überblick dargestellt.

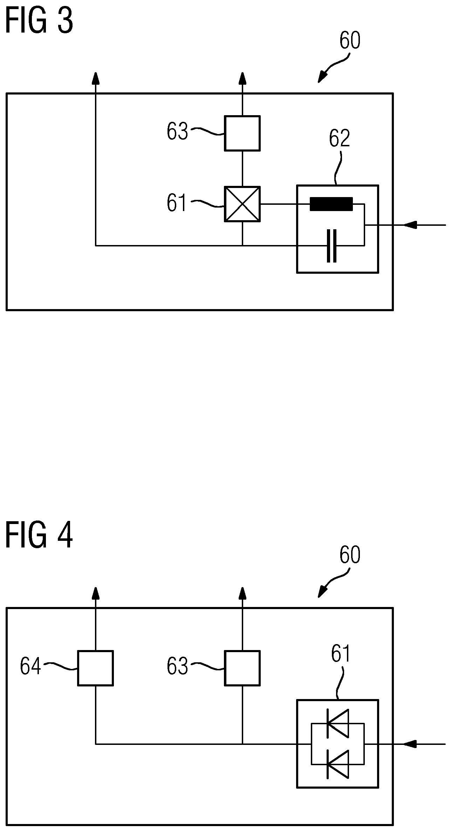

Die Antennenspulen 51 empfangen Magnetresonanzsignale aus dem Körper des Patienten 40. Vorzugsweise decken die beiden Antennenspulen 51 dabei unterschiedliche räumliche Bereiche ab. Die schwachen Magnetresonanzsignale werden zunächst von einem rauscharmen Vorverstärker 52 (Low Noise Amplifier, LNA) verstärkt. Damit die Signale separat ausgewertet werden können, werden sie für eine Übertragung mittels Frequenzmultiplex auf einer gemeinsamen Leitung von einem ersten Mischer 53 und einem zweiten Mischer 54 auf unterschiedliche Zwischenfrequenzen ZF1 und ZF2 umgesetzt. Die Mischfrequenzsignale für den ersten Mischer 53 und den zweiten Mischer 54 werden wie nachfolgend zu Fig. 3 und Fig. 4 erläutert von dem Lokaloszillator 60 bereitgestellt. Als Mischer 53, 54 sind beispielsweise Ringmischer, Gegentaktmischer oder als einfacher Diodenmischer ausgeführt. Auch eine Ausführung in der digitalen Signalverarbeitung, z.B. als Multiplikator oder Und-Gatter denkbar.

Um unerwünschte Mischprodukte zu unterdrücken, werden vorzugsweise die Ausgangssignale des ersten Mischers 53 und des zweiten Mischers 54 mittels eines ersten Filters 55 und eines zweiten Filters 56 spektral gesäubert, d.h. unerwünschte Frequenzanteile werden gegenüber erwünschten Signalen um 6 dB. 12 dB oder mehr gedämpft. Es kann sich bei dem ersten Filter 55 und dem zweiten Filter 56 beispielsweise um Bandpässe jeweils mit der Mittenfrequenz ZF1 bzw. ZF2 handeln. Der erste Filter 55 und der zweite Filter 56 können beispielsweise als passive oder aktive LC- bzw. RC-Filter ausgeführt sein, durch andere analoge Filtertechniken wie Quarz- oder Oberflächenwellenfilter oder auch durch digitale Signalverarbeitung realisiert sein.

Die gefilterten Ausgangssignale des ersten Mischers 53 und des zweiten Mischers 54 werden zusammengeführt, beispielsweise durch ein Summierglied 57 in Form von zwei Widerständen und über einen zweiten Diplexer 58 auf die gemeinsame Signalverbindung 33 ausgegeben. Als zweiter Diplexer 58 können bei unterschiedlichen Frequenzbereichen für die Hilfsfrequenzsignale und die Zwischenfrequenzsignale Bandpass- oder Hoch- und Tiefpass-Filter dienen, es sind aber auch andere Technologien wie z.B. ein Gyrator zum Zusammenführen bzw. Trennen der ein- und ausgehenden Signale denkbar.

In Fig. 3 ist eine beispielhafte Ausführungsform eines Lokaloszillators 60 dargestellt. In der Ausführungsform der Fig. 3 werden das erste Hilfsfrequenzsignal und das zweite Hilfsfrequenzsignal gemeinsam über eine erste Signalverbindung dem ersten Diplexer 62 zugeführt, der das erste Hilfsfrequenzsignal von dem zweiten Hilfsfrequenzsignal trennt und einer zweiten Signalverbindung und einer dritten Signalverbindung getrennt bereitstellt. Als Trennen ist dabei zu verstehen, dass das jeweils unerwünschte Signal um 6 dB, 12 dB 18 dB oder mehr gegenüber dem erwünschten Signal gedämpft ist.

In der in Fig. 3 dargestellten Ausführungsform ist dabei das erste Mischfrequenzsignal, das dem ersten Mischer 53 zugeführt wird, im Wesentlichen identisch mit dem ersten Hilfsfrequenzsignal, d.h. die Frequenzlage bzw. die Mittenfrequenz ist die gleiche und die Pegel sind nur geringfügig durch den Frequenzgang des ersten Diplexers 62 und des zweiten Diplexers 58 gegenüber dem über den Signaleingang von der Signalverbindung 33 zugeführten verändert.

Das zweite Mischfrequenzsignal wird durch den Hilfsmischer 61 aus dem ersten Hilfsfrequenzsignal und dem zweite Hilfsfrequenzsignal und das nachfolgende Filter 63 durch Mischung erzeugt. Dabei ist weist der erste Hilfsmischer vorzugsweise eine Bauform auf, bei der das ursprünglich zugeführte erste Hilfsfrequenzsignal und das zweite Hilfsfrequenzsignal im zweiten Mischfrequenzsignal um 6 dB, 12 dB oder mehr unterdrückt ist. Beispielsweise kann der Hilfsmischer als Ringmischer oder Gegentaktmischer ausgeführt sein. Durch die Unterdrückung der ursprünglichen Hilfsfrequenzsignale im Hilfsmischer kann der Filter 63 einfacher ausgeführt sein, beispielsweise als einfacher Tiefpass.

In einer Ausführungsform der Fig. 3 können beispielsweise als Frequenzen der Hilfsfrequenzsignale 35 MHz und 50 MHz gewählt werden und als Frequenz des ersten Mischfrequenzsignals 35 MHz und als Frequenz des zweiten Mischfrequenzsignals 15 MHz.

Fig. 4 zeigt eine andere mögliche Ausführungsform des Lokaloszillators 60. Bei dieser Ausführungsform ist kein erster Diplexer 62 erforderlich, sondern das erste Hilfsfrequenzsignal und das zweite Hilfsfrequenzsignal werden dem Hilfsmischer 61 über eine gemeinsame Signalverbindung zugeführt. Als Hilfsmischer 61 ist in dieser Ausführungsform ein nichtlineares Element denkbar, beispielsweise eine oder auch zwei antiparallel geschaltete Dioden. Auch andere nichtlineare Verstärkerelemente wie Transistoren im nichtlinearen Kennlinienbereich sind möglich. Derartige nichtlineare Mischer erzeugen am Signalausgang nicht nur die Mischsignale zweiter Ordnung mit einer Frequenz, die jeweils der Summe bzw. der Differenz der Frequenzen des ersten Hilfsfrequenzsignals und des zweiten Hilfsfrequenz entsprechen, sondern es entstehen auch Mischprodukte höherer Ordnung. Darüber hinaus liegen am Signalausgang des Hilfsmischers 61 in einer derartigen Ausführungsform auch das erste Hilfsfrequenzsignal und das zweite Hilfsfrequenzsignal mit vergleichbarem Pegel an.

In der Ausführungsform de Fig. 4 weist der Lokaloszillator deshalb auch Filter 63, 64 auf, mit denen aus dem Ausgangssignal des Hilfsmischers 61 das gewünschte erste Mischfrequenzsignal und das gewünschte zweite Mischfrequenzsignal herausgefiltert werden. Als Filter können dabei die zuvor genannten analogen oder digitalen Filtertechniken Anwendung finden.

Die zusätzlich erzeugten Mischprodukte höherer Ordnung erfordern dabei zwar den größeren Aufwand in der Filterung, erlauben aber die Verwendung preisgünstiger Mischertechniken und geben durch die zusätzlichen Mischprodukte zusätzliche Freiheitsgrade bei der Wahl der der Frequenzen der Hilfsfrequenzsignale, der Mischfrequenzsignale und der Zwischenfrequenzen.

In einer Ausführungsform der Fig. 4 können beispielsweise als Frequenzen der Hilfsfrequenzsignale 35 MHz und 55 MHz gewählt werden und als Frequenz des ersten Mischfrequenzsignals 35 MHz und als Frequenz des zweiten Mischfrequenzsignals 15 MHz.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspule mit Vorrichtung zum Bereitstellen eines ersten Mischfrequenzsignals und eines zweiten Mischfrequenzsignals mittels eines ersten Hilfsfrequenzsignals und eines zweiten Hilfsfrequenzsignals,
wobei die Lokalspule (50) Antennenspulen (51) aufweist, die ausgelegt sind, Magnetresonanzsignale aus dem Körper des Patienten (40) zu empfangen,
wobei die Lokalspule (50) einen ersten Mischer (53) und einen zweiten Mischer (54) aufweist, der ausgelegt ist, die Magnetresonanzsignale für eine Übertragung mittels Frequenzmultiplex auf einer gemeinsamen Leitung auf unterschiedliche Zwischenfrequenzen umzusetzen,
wobei die Vorrichtung einen Lokaloszillator (60) aufweist, der ausgelegt ist das erste Mischfrequenzsignal und das zweite Mischfrequenzsignal für den ersten Mischer (53) und den zweiten Mischer (54) bereitzustellen,
wobei höchstens die Frequenz des ersten Mischfrequenzsignals gleich einer Frequenz eines von dem ersten Hilfsfrequenzsignal oder dem zweiten Hilfsfrequenzsignal ist,
wobei die Vorrichtung einen Hilfsmischer (61) aufweist, der ausgelegt ist, aus dem ersten Hilfsfrequenzsignal und dem zweiten Hilfsfrequenzsignal das zweite Mischfrequenzsignal zu erzeugen,
wobei die Lokalspule (50) einen Signaleingang aufweist, der in einer ersten Signalverbindung mit der Vorrichtung steht und die Lokalspule (50) ausgelegt ist, das erste Hilfsfrequenzsignal und das zweite Hilfsfrequenzsignal gemeinsam über den Signaleingang zu empfangen und der Vorrichtung über die erste Signalverbindung zuzuführen.

2. Lokalspule nach Anspruch 1, wobei die Vorrichtung einen ersten Diplexer (62) aufweist und eine zweite Signalverbindung und eine dritte Signalverbindung zwischen dem ersten Diplexer (62) und dem Hilfsmischer (61) aufweist,
wobei der erste Diplexer (62) ausgelegt ist, die über die erste Signalverbindung gemeinsam zugeführten erste Hilfsfrequenzsignal und zweite Hilfsfrequenzsignal zu trennen und getrennt über die zweite Signalverbindung und die dritte Signalverbindung dem Hilfsmischer (61) zuzuführen.

3. Lokalspule nach Anspruch 1, wobei der Hilfsmischer (61) ausgelegt ist, das zweite Mischfrequenzsignal durch Intermodulation dritter Ordnung zu erzeugen.

4. Lokalspule nach Anspruch 3, wobei die Vorrichtung ein Bandpassfilter aufweist, das eine vierte Signalverbindung zu einem ersten Signalausgang des Hilfsmischers aufweist und ausgelegt ist, das zweite Mischfrequenzsignal aus einem Ausgangssignal des Hilfsmischers zu filtern.

5. Lokalspule nach Anspruch 3, wobei der Hilfsmischer (61) einen Diodenverzerrer aufweist.

6. Magnetresonanztomograph mit einer Lokalspule (50) nach einem der vorhergehenden Ansprüche, wobei der Magnetresonanztomograph (1) einen Frequenzgenerator (35) aufweist und ausgelegt ist, das erste Hilfsfrequenzsignal und das zweite Hilfsfrequenzsignal an einem zweiten Signalausgang bereitzustellen.

7. Magnetresonanztomograph nach Anspruch 6, wobei der Magnetresonanztomograph (1) einen Empfänger mit einem Signaleingang aufweist, wobei der Empfänger ausgelegt ist, Empfangssignale mit einer Frequenz eines Mischsignals aus einem Magnetresonanzsignal mit Larmorfrequenz und erstem Mischfrequenzsignal und/oder zweitem Mischfrequenzsignal am Signaleingang zu empfangen und auszuwerten.

## Claims

1. Local coil with a device for providing a first mixed frequency signal and a second mixed frequency signal by means of a first auxiliary frequency signal and a second auxiliary frequency signal,
wherein the local coil (50) has antenna coils (51), which are designed to receive magnetic resonance signals from the body of the patient (40),
wherein the local coil (50) has a first mixer (53) and a second mixer (54), which is designed to convert the magnetic resonance signals to different intermediate frequencies for transmission by means of frequency-division multiplexing on a shared line
wherein the device has a local oscillator (60), which is designed to provide the first mixed frequency signal and the second mixed frequency signal for the first mixer (53) and the second mixer (54),
wherein at most the frequency of the first mixed frequency signal is equal to a frequency of one of the first auxiliary frequency signal or the second auxiliary frequency signal,
wherein the device has an auxiliary mixer (61) which is designed to generate the second mixed frequency signal from the first auxiliary frequency signal and the second auxiliary frequency signal,
wherein the local coil (50) has a signal input which is connected to a first signal connection with the device and the local coil (50) is designed to receive the first auxiliary frequency signal and the second auxiliary frequency signal jointly by way of the signal input and supply them to the device by way of the first signal connection.

2. Local coil according to claim 1, wherein the device has a first diplexer (62) and a second signal connection and a third signal connection between the first diplexer (62) and the auxiliary mixer (61),
wherein the first diplexer (62) is designed to separate the first auxiliary frequency signal and the second auxiliary frequency signal jointly supplied by way of the first signal connection and supply them separately to the auxiliary mixer (61) by way of the second signal connection and the third signal connection.

3. Local coil according to claim 1, wherein the auxiliary mixer (61) is designed to generate the second mixed frequency signal by means of third-order intermodulation.

4. Local coil according to claim 3, wherein the device has a bandpass filter which has a fourth signal connection to a first signal output of the auxiliary mixer and is designed to filter the second mixed frequency signal out of an output signal of the auxiliary mixer.

5. Local coil according to claim 3, wherein the auxiliary mixer (61) has diode distortion.

6. Magnetic resonance scanner with a local coil (50) according to one of the preceding claims, wherein the magnetic resonance scanner (1) has a frequency generator (35) and is designed to provide the first auxiliary frequency signal and the second auxiliary frequency signal at a second signal output.

7. Magnetic resonance scanner according to claim 6, wherein the magnetic resonance scanner (1) has a receiver with a signal input, wherein the receiver is designed to receive and evaluate received signals with a frequency of a mixed signal from a magnetic resonance signal with a Larmor frequency and a first mixed frequency signal and/or a second mixed frequency signal at the signal input.

## Revendications

1. Bobine locale à système de mise à disposition d'un premier signal de fréquence superposé et d'un deuxième signal de fréquence superposé au moyen d'un premier signal de fréquence auxiliaire et d'un deuxième signal de fréquence auxiliaire,
dans laquelle la bobine (50) locale a des bobines (51) d'antenne conçues pour recevoir des signaux de résonance magnétique du corps du patient (40),
dans laquelle la bobine (50) locale a un premier mélangeur (53) et un deuxième mélangeur (54) conçu pour transformer les signaux de résonance magnétique pour une transmission au moyen d'un multiplexage de fréquence sur une ligne commune en des fréquences intermédiaires différentes,
dans laquelle le système a un oscillateur (60) local conçu pour mettre le premier signal de fréquence superposé et le deuxième signal de fréquence superposé à la disposition du premier mélangeur (53) et du deuxième mélangeur (54),
dans laquelle la fréquence du premier signal de fréquence superposé est égale au plus à la fréquence de l'un du premier signal de fréquence auxiliaire ou du deuxième signal de fréquence auxiliaire,
dans laquelle le système a un mélangeur (61) auxiliaire conçu pour produire le deuxième signal de fréquence superposé à partir du premier signal de fréquence auxiliaire et du deuxième signal de fréquence auxiliaire,
dans laquelle la bobine (50) locale a une entrée du signal, qui est dans une première communication de signal avec le système, et la bobine (50) locale est conçue pour recevoir le premier signal de fréquence auxiliaire et le deuxième signal de fréquence auxiliaire, conjointement par l'entrée du signal et l'envoyer au système par la première communication du signal.

2. Bobine locale suivant la revendication 1, dans laquelle le système a un premier diplexeur (62) et a une deuxième communication du signal et une troisième communication du signal entre le premier diplexeur (62) et le mélangeur (61) auxiliaire,
dans laquelle le premier diplexeur (62) est conçu pour séparer le premier signal de fréquence auxiliaire et le deuxième signal de fréquence auxiliaire envoyés conjointement par la première communication de signal et pour les envoyer au mélangeur (61) auxiliaire séparément par la deuxième communication de signal et la troisième communication de signal.

3. Bobine locale suivant la revendication 1, dans laquelle le mélangeur (61) auxiliaire est conçu de manière à produire le deuxième signal de fréquence superposé par intermodulation de troisième ordre.

4. Bobine locale suivant la revendication 3, dans laquelle le système à un filtre passe-bande, qui a une quatrième communication du signal vers une première sortie du signal du mélangeur auxiliaire et est conçu pour filtrer le deuxième signal de fréquence superposé d'un signal de sortie du mélangeur auxiliaire.

5. Bobine locale suivant la revendication 3, dans laquelle le mélangeur (61) auxiliaire a un déformeur à diode.

6. Tomographe à résonance magnétique, comprenant une bobine (50) locale suivant l'une des revendications précédentes, le tomographe (1) à résonance magnétique ayant un générateur (35) de fréquence et étant conçu pour mettre le premier signal de fréquence auxiliaire et le deuxième signal de fréquence auxiliaire à la disposition d'une deuxième sortie du signal.

7. Tomographe à résonance magnétique suivant la revendication 6, dans lequel le tomographe (1) à résonance magnétique a un récepteur ayant une entrée du signal, le récepteur étant conçu pour recevoir, à l'entrée du signal, et exploiter des signaux de réception ayant une fréquence d'un signal superposé composée d'un signal de résonance magnétique à la fréquence de Larmor et du premier signal de fréquence superposé et/ou du deuxième signal de fréquence superposé.
